# EUROPEAN PATENT SPECIFICATION

(11) **EP 0 392 630 B1**
(45) Date of publication and mention of the grant of the patent: **28.06.1995**
(21) Application number: 90200882.0
(22) Date of filing: 10.04.1990
(51) Int. Cl.: H01L 39/24

(54) **Method for applying a layer of superconducting material and a device suitable therefor**
Verfahren zum Aufbringen einer Schicht aus supraleitenden Materialien und geeignete Anordnung
Procédé de dépôt d'une couche d'un matériau supraconducteur et dispositif pour la mise en oeuvre

(30) Priority: 10.04.1989 EP 89200904; 29.01.1990 NL 9000214
(43) Date of publication of application: 17.10.1990
(73) Proprietor: INTERUNIVERSITAIR MICROELEKTRONICA CENTRUM VZW, 3030 Leuven-Heverlee (BE)
(72) Inventor: Deneffe, Kristin, B-3079 Meerbeek (BE); Borghs, Gustaaf Regina, B-3200 Kessel-Lo (BE)
(74) Representative: Land, Addick Adrianus Gosling

(56) References cited:
- WO-A-89/08605
- US-A- 4 673 482
- APPLIED PHYSICS LETTERS. vol. 53, no. 3, 18 July 1988, NEW YORK, US, pages 234 -236; S. WITANACHCHI et al: "Deposition of superconducting Y-Ba-Cu-O films at 400 C without post-annealing"
- APPLIED PHYSICS LETTERS. vol. 52, no. 4, 25 January 1988, NEW YORK, US, pages 320- 322; L.LYNDS et al: "Superconducting thin films of Y-Ba-Cu-O produced by neodymium:yttrium aluminum garnet laser ablation"

## Description

A worldwide search is going on for a method for applying superconducting layers with high critical temperature which can moreover be combined with other microelectronic layers. Sputtering, vapour deposition, precipitation with molecular bundles and laser ablation are the main prior arts in this field. This mainly involves orthorhombic materials such as Y₁ Ba₂ Cu₃ O_{7-δ}, wherein an additional oxygen treatment is often used after precipitation and annealing steps are applied at a high temperature (± 900°C). The drawback of these prior art comprises the diffusion and/or chemical reactions between substrate and the superconducting layer to be applied thereto, particularly in the case of semiconductor substrates such as gallium arsenide (GaAs) and silicon (Si). The difference in coefficient of expansion between the different materials may also be a cause of christal-grid errors.

In the article "Deposition of superconducting Y-Ba-Cu-O filmed at 400°C without post-annealing" by S. Witanachichi et al., APPLIED PHYSICS LETTERS vol. 53, no. 3, 18 juli 1988 New York USA, pages 234-236 a method is disclosed for applying a layer of superconducting Y₁ Ba₂ Cu₃ 0_{7-δ} Onto a substrate by the method of plasma assisted laser deposition (pld).

US-A-4 673 482 discloses a sputtering apparatus for sputtering magnetic materials. The apparatus comprises one pair of magnetic field generating sources and a substrate disposed within the magnetic field generating sources. The magnetic field is used to orient the magnetic domains in the films deposited with this apparatus.

The present invention has for its object to improve the above mentioned prior art and provides to this end a method according to claim 1.

The present invention also provides a device as according to claim 3 wherein other micro-electronic layers such as conducting layers and the like can also be applied in a simple manner. The (dry) etching of layers can also take place in such a device.

Further advantages, features and details of the present invention will be elucidated on the basis of a description of a preferred embodiment thereof with reference to the annexed figure.

A device 1 comprises a chamber 2 wherein a substrate S is disposed on a substrate holder 3. A laser bundle B is directed via an entrance or window 4 onto a superconducting piece of material M according to the per se known ablation technique so that material to be applied to the substrate S is released form the piece of material. A holder 5 for the material M preferably takes a rotating form so that overheating thereof is avoided. On either side of the chamber 2 is arranged a schematically indicated microwave system 6 comprising two solenoids (7, 8).

The magnetic field generated by the solenoids 7,8 is preferably dimensioned such that at two spots in this field the value is 875x10⁻⁴ T (875 Gauss). Oxygen, which is brought into the chamber in a manner not shown is ionised at these spots and enters a plasma state in the area between the two spots. The generated ions are transported along the magnetic field lines over the substrate. Since interaction with the chamber walls is avoided as far as possible, a pure and clean plasma is produced resulting in pure and clean layers.

With the microwave system shown here is avoided the use of a separate discharge cell or an extra quartz tube for keeping the plasma away from the walls of a chamber.

In a manner not shown the chamber 2 is kept at underpressure, for example of 1.3x10⁻⁷ Pa (10⁻⁹ Torr), using a Balzer TM pump (not shown).

In addition, the device 1 is preferably provided with Knudsen or effusion cells (9, 11) for applying other layers.

A YAG laser (12) is preferably galvanically controlled so that patterns can be written onto a substrate herewith.

It will be apparent that with the device shown a method becomes possible wherein different layers can be applied to GaAs or Si substrates at a low temperature (about 400°C) wherein interactions, that is, diffusion or reactions, between substrate and layers to be applied thereon are avoided as far as possible. In addition an efficient transporting of the oxygen containing plasma takes place over the substrate along the magnetic field lines because of the dimensioning of that magnetic field. Even at a pressure of only 1,3 x 10⁻³ - 1,3 x 10⁻⁵ Pa (10⁻⁵-10⁻⁷ Torr) the plasma will ignite. Optional passivisation of a superconducting layer using an oxide layer can be performed without oxygen being extracted from the superconducting layer as sufficient oxygen can be brought into the plasma.

Both etching using a plasma and writing patterns using a laser will be possible with the device shown, wherein is avoided that the substrate would have to be taken out of a vacuum chamber and therefore impurities and the like thereon are likewise avoided.

The method can also be used for deposition of other layers such as diamond or epitaxial silicium.

### EXAMPLE

A layer was grown in a plasma with an oxygen pressure of 6,5 x 10⁻² Pa (5 x 10⁻⁴ Torr) and after that "quenched", i.e. chilled as quickly as possible.

The resistance of the layer was measured. On a rough (roughness 5 microns), unpolished, poly-crystalline YSZ substrate an onset temperature of 85K was obtained. The offset (R=O) temperature was 75K. These results are the best that can be expected when using an YSZ substrate .

In order to prove that the reactive excited oxygen atoms and ions guarantee a sufficient oxidation of every layer two identical YBCO layers were grown according to the above mentioned method. One of the layers was grown in the presence of the oxygen plasma while the other one was grown in the presence of neutral oxygen molecules. Measuring the resistance showed that the first layer was superconductive while the second one was not.

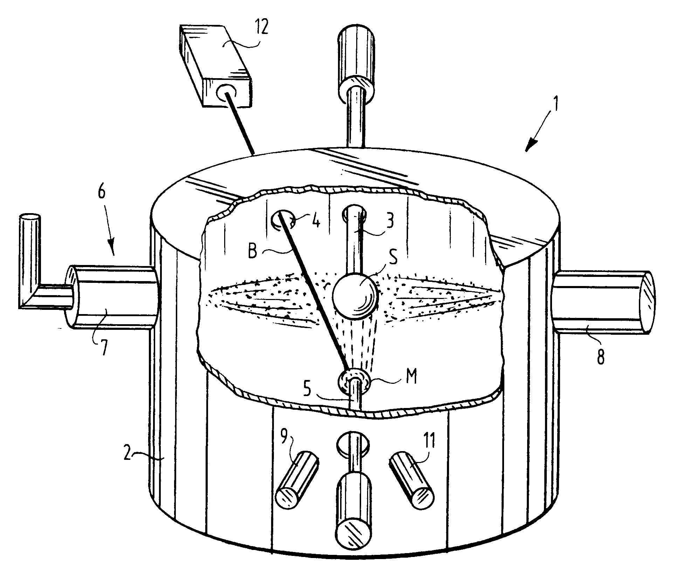

## Claims

1. A method for applying a layer of superconducting material in the form of a copper oxide superconducting ceramic onto a substrate comprising the following steps:
- releasing at least a part of the material to be applied in an environment of underpressure using a laser bundle;
- bringing oxygen into a plasma state close to the substrate; and
- applying a magnetic field of such value that close to the edges of the substrate the oxygen is ionized to enter into a plasma state and subsequently transported over the substrate along field lines of said magnetic field which are substantially parallel to the substrate's surface.

2. A method as claimed in claim 1, wherein the material is Y₁ Ba₂ Cu₃ O_{7-δ}.

3. An apparatus (1) for applying one or more layers to a substrate (S), comprising:
- a substrate holder (3);
- an entrance (4) for a laser bundle;
- an entrance port for the material (M) to be radiated with the laser bundle (B);
- means for generating an underpressure in the apparatus;
- an entrance for oxygen or another gas; characterised by
- two solenoids (7,8) arranged substantially opposite one another for generating a magnetic field close to the substrate holder for ionizing the gas introduced into the chamber by the magnetic field generated by the solenoids, and in that said solenoids (7,8) are positioned such that the magnetic field lines generated by said solenoids are substantially parallel to the substrates surface.

4. An apparatus according to claim 3, provided with a quadrupole for residual gas analysis.

5. An apparatus according to claim 3 or 4, provided with one or more Knudsen cells (9,11) for carrying material for precipitation into a chamber (2) thereof.

## Patentansprüche

1. Verfahren zum Aufbringen einer Schicht aus supraleitendem Material in Form einer Kupferoxid-supraleitenden Keramik auf ein Substrat, mit den folgenden Schritten:
- Lösen mindestens eines Teils des aufzubringenden Materials in einer Unterdruck aufweisenden Umgebung unter Verwendung eines Laserbündels;
- Überführen von Sauerstoff in einen Plasmazustand nahe dem Substrat; und
- Anlegen eines Magnetfeldes mit einem derartigen Wert, daß nahe den Substratkanten der Sauerstoff ionisiert wird, um in den Plasmazustand überzugehen, und anschließend über das Substrat entlang Feldlinien des Magnetfeldes transportiert wird, welche im wesentlichen parallel zur Substratoberfläche sind.

2. Verfahren nach Anspruch 1, wobei das Material Y₁, Ba₂, Cu₃, O_{7-δ}.

3. Vorrichtung (1) zum Aufbringen einer oder mehrerer Schichten auf ein Substrat (S) mit:
- einem Substratträger (3);
- einem Eingang (4) für ein Laserbündel;
- einer Eingangsöffnung für das mit dem Laserbündel (B) zu bestrahlende Material (M);
- Mitteln zum Erzeugen eines Unterdruckes in der Vorrichtung;
- einem Eingang für Sauerstoff oder ein anderes Gas;
gekennzeichnet durch
- zwei Solenoiden (7,8), welche im wesentlichen einander gegenüberliegend angeordnet sind, so daß sie ein Magnetfeld nahe dem Substratträger zum Ionisieren des in die Kammer eingebrachten Gases durch das durch die Solenoiden erzeugte Magnetfeld erzeugen, und dadurch, daß die Solenoiden (7,8) derart angeordnet sind, daß die durch die Solenoiden erzeugten Magnetfeldlinien im wesentlichen parallel zur Substratoberfläche sind.

4. Vorrichtung nach Anspruch 3, mit einem Quadrupol für eine Analyse der verbleibenden Gase.

5. Vorrichtung nach Anspruch 3 oder 4, mit einer oder mehrerer Knudsen-Zellen (9,11) zum Transportieren bzw. Tragen von Fällungsmaterialien in ihre Kammer (12).

## Revendications

1. Procédé pour déposer une couche de matière supraconductrice sous la forme d'une céramique supraconductrice faite d'oxyde de cuivre sur un substrat, comprenant les phases suivantes :
- détacher au moins une partie de la matière à déposer dans un environnement de dépression à l'aide d'un faisceau laser ;
- mettre l'oxygène à l'état de plasma à proximité du substrat ; et
- appliquer un champ magnétique d'une valeur telle qu'à proximité des bords du substrat, l'oxygène soit ionisé pour prendre l'état de plasma et qu'il soit ensuite transporté sur le substrat le long de lignes de force dudit champ magnétique qui sont sensiblement parallèles à la surface du substrat.

2. Procédé selon la revendication 1, dans lequel la matière est Y₁ Ba₂ Cu₃ O_{7-δ}.

3. Appareil (1) pour déposer une ou plusieurs couches sur un substrat (S), comprenant :
- un porte-substrat (3) ;
- une entrée (4) pour un faisceau laser ;
- un orifice d'entrée pour la matière (M) à irradier au moyen du faisceau laser (B) ;
- des moyens servant à engendrer une dépression dans l'appareil ;
- une entrée pour l'oxygène ou un autre gaz ;
caractérisé par :
- deux solénoïdes (7, 8) disposés sensiblement face à face pour engendrer un champ magnétique à proximité du porte-substrat pour ioniser le gaz introduit dans la chambre au moyen du champ magnétique engendré par les solénoïdes, et en ce que lesdits solénoïdes (7, 8) sont positionnés de manière que les lignes de force du champ magnétique engendré par lesdits solénoïdes soient sensiblement parallèles à la surface du substrat.

4. Appareil selon la revendication 3, équipé d'un quadripôle pour l'analyse des gaz résiduels.

5. Appareil selon la revendication 3 ou 4, équipé d'une ou plusieurs cellules de Knudsen (9, 11) servant à introduire une matière destinée à être précipitée dans une chambre (2) de cet appareil.
